(19) Europäisches Patentamt / European Patent Office / Office européen des brevets

(11) **EP 4 333 312 B1**

(12) **FASCICULE DE BREVET EUROPEEN**

(45) Date de publication et mention
de la délivrance du brevet:
**27.11.2024 Bulletin 2024/48**

(21) Numéro de dépôt: **23190327.9**

(22) Date de dépôt: **08.08.2023**

(51) Classification Internationale des Brevets (IPC):
**H04B 1/04** *(2006.01)*    **H03F 1/32** *(2006.01)*
**H03F 3/195** *(2006.01)*    **H03F 3/24** *(2006.01)*
**H03M 3/00** *(2006.01)*

(52) Classification Coopérative des Brevets (CPC):
**H04B 1/0475; H03F 1/3247; H03F 1/3258;
H03F 3/195; H03F 3/245;** H03M 3/458;
H04B 1/0483; H04B 2001/0425

(54) **DISPOSITIF EMETTEUR, PROCEDES DE PREDISTORSION ET DE DECORRELATION DE BRUIT DANS UN TEL DISPOSITIF EMETTEUR**

SENDERVORRICHTUNG, VORVERZERRUNGSVERFAHREN UND RAUSCHKORRELATION IN EINER SOLCHEN SENDERVORRICHTUNG

TRANSMITTER DEVICE, METHODS FOR PRE-DISTORTION AND DE-CORRELATION OF NOISE IN SUCH A TRANSMITTER DEVICE

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.08.2022 FR 2208651**

(43) Date de publication de la demande:
**06.03.2024 Bulletin 2024/10**

(73) Titulaire: **Commissariat à l'Energie Atomique et aux Energies Alternatives
75015 Paris (FR)**

(72) Inventeur: **MORCHE, Dominique
38054 GRENOBLE Cedex 09 (FR)**

(74) Mandataire: **Atout PI Laplace
Immeuble Up On
25 Boulevard Romain Rolland
CS 40072
75685 Paris Cedex 14 (FR)**

(56) Documents cités:
**US-A1- 2005 110 562    US-A1- 2012 269 291**

• **OTHMANI MAROUAN ET AL: "Delta-Sigma Modulator-Embedded Digital Predistortion for 5G Transmitter Linearization", IEEE TRANSACTIONS ON COMMUNICATIONS, IEEE SERVICE CENTER, PISCATAWAY, NJ. USA, vol. 70, no. 8, 16 June 2022 (2022-06-16), pages 5558 - 5571, XP011916878, ISSN: 0090-6778, [retrieved on 20220617], DOI: 10.1109/TCOMM.2022.3184167**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

**Domaine technique** :

L'invention se situe dans le domaine des dispositifs d'émission de signaux comprenant un amplificateur de puissance et effectuant une opération de prédistorsion numérique pour compenser la non-linéarité de cet amplificateur de puissance.

**Technique antérieure** :

La prédistorsion est une opération connue (cf. par exemple H. Qian, H. Huang and S. Yao, "A General Adaptive Digital Predistortion Architecture for Stand-Alone RF Power Amplifiers," in IEEE Transactions on Broadcasting, vol. 59, no. 3, pp. 528-538, Sept. 2013), qui consiste à compenser la non-linéarité de l'amplificateur en ajoutant au signal présenté à l'entrée de celui-ci une non-linéarité inverse, de sorte qu'on obtienne une fonction de transfert linéaire pour l'ensemble comprenant le module de prédistorsion et l'amplificateur.

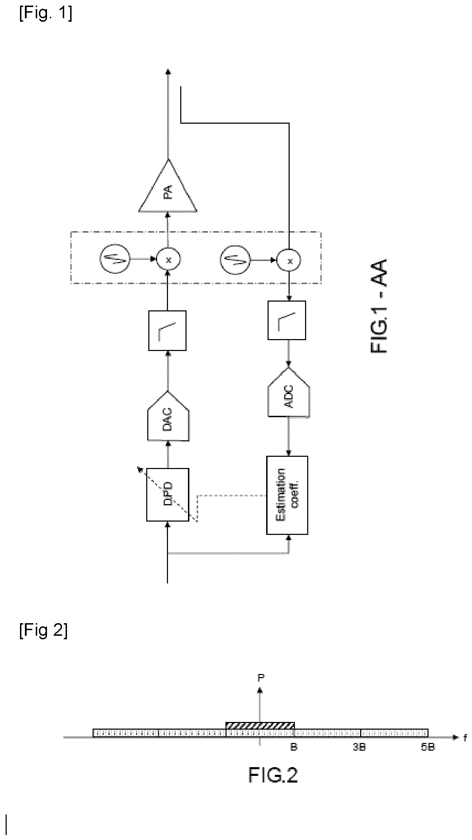

La figure 1 représente un schéma de principe qui illustre un exemple d'architecture de dispositif émetteur avec prédistorsion connu. Il comporte une voie de traitement en émission recevant le signal utile en bande de base et, qui, sur chacune de deux chaînes de traitement I, Q destinées à traiter l'une le signal en phase (I) sélectivement et l'autre, le signal en quadrature de phase (Q) sélectivement, comporte un bloc de prédistorsion numérique suivi d'un convertisseur numérique-analogique (DAC), dun filtre analogique pour supprimer le bruit, d'un étage de changement de fréquence (optionnel) pour transposer le signal sur une porteuse (seule une chaîne de traitement est représentée en figure 1). La voie de traitement comporte enfin un amplificateur de puissance (PA).

Le bloc de prédistorsion numérique effectue une opération de prédistorsion en fonction de coefficients de prédistorsion.

Le dispositif émetteur comporte en outre une voie de retour qui permet de déterminer les effets de la variation du gain de l'amplificateur de puissance en fonction de la puissance du signal numérique fourni en entrée de la voie de traitement en émission. Un coupleur (ou tout autre dispositif de mesure) est utilisé en sortie de cet amplificateur de puissance pour obtenir le signal en sortie de l'amplificateur de puissance. La voie de retour comporte un étage de changement de fréquence (optionnel) pour transposer le signal en bande de base, et sur, chacune de deux chaînes de traitement destinées à traiter l'une le signal en phase (I) sélectivement et l'autre, le signal en quadrature de phase (Q) sélectivement (seule une de ces chaînes est représentée en figure 1), un filtre analogique, un convertisseur analogique-numérique (ADC), un bloc d'estimation des coefficients de prédistorsion, adapté pour effectuer cette estimation en fonction au moins du signal en sortie du convertisseur et du signal utile en entrée de la voie de traitement en émission. Les coefficients de prédistorsion actualisés sont ensuite délivrés au bloc de prédistorsion (de la chaîne I, respectivement Q), qui les utilise pour effectuer les prédistorsions suivantes.

Les non-linéarités de l'amplificateur de puissance créent des harmoniques du signal qui sont représentées sur la figure 2 illustrant le spectre du signal en sortie de l'amplificateur. La puissance de signal utile, fourni en entrée de la voie de traitement en émission, est représentée en fonction de la fréquence en hachuré. Le signal a une bande passante +/- B par rapport à la fréquence centrale. La non-linéarité conférée par l'amplificateur est souvent modélisée par une fonction de transfert de l'amplificateur de puissance sous forme polynomiale. Pour simplifier l'explication, on fait l'hypothèse ici que ce polynôme est d'ordre r, avec par exemple r=5. Cette non-linéarité de l'amplificateur de puissance, va donc générer du bruit dans la bande (en pointillé en figure 2) qui va limiter les performances du dispositif émetteur. Elle va également générer des produits d'intermodulation du signal d'entrée qui vont se trouver à l'extérieur de la bande du signal utile : dans l'exemple considéré avec r=5, de B à 3B pour les harmoniques d'ordre 3 et de 3B à 5B pour les harmoniques d'ordre 5.

De nombreux algorithmes peuvent être utilisés pour extraire ces non-linéarités. Une solution est de se focaliser sur le signal en dehors de la bande passante du signal d'entrée (dans le cas r= 5 : dans les bandes [B,3B] pour l'harmonique 3 et [3B,5B] pour l'harmonique 5) : cf. par exemple D. G. Pham, P. Desgreys, M. A. Hussein, P. Loumeau and O. Venard, "Impact of subband quantization on DPD correction performance," 2013 IEEE 20th International Conférence on Electronics, Circuits, and Systems (ICECS), 2013).

L'intérêt est que dans ces bandes passantes, les produits d'intermodulation, issus de la distorsion du signal se retrouvent isolés du signal d'entrée, situé à plus basse fréquence. L'analyse de ces différentes bandes va permettre aussi de pouvoir dissocier les différents coefficients du modèle non linéaire.

La solution décrite ici est une approche classique qui présente l'inconvénient d'avoir potentiellement besoin d'un DAC avec un grand nombre de bits (pour ne pas dégrader le rapport signal à bruit du signal dans la bande et en dehors de la bande). Ce nombre de bits élevé est gênant parce qu'il implique une complexité importante pour le DAC (qui va engendrer une forte surface et une consommation élevée) et, dans le cas où le DAC et le circuit numérique de génération des signaux modulés sont séparés, il faut disposer de nombreuses sorties digitales en sortie du circuit numérique de modulation des données et de nombreuses entrées sur le circuit contenant le DAC. Ce phénomène est d'autant plus problématique dans les dispositifs émetteurs multivoies puisqu'il faut multiplier le nombre de bits du DAC par le nombre de voies pour obtenir le nombre de bits à transférer.

Il est connu de positionner un codeur sigma-delta en amont du DAC : cf. H. H. Boo, S. W. Chung and J. L. Dawson, "Adaptive Predistortion Using a $\Delta\Sigma$ Modulator for Automatic Inversion of Power Amplifier Nonlinearity," in IEEE Transactions on Circuits and Systems II: Express Briefs, vol. 56, no. 12, pp. 901-905, Dec. 2009.

Cette solution permet de réduire le nombre de bits du DAC en contrepartie d'avoir une fréquence d'échantillonnage élevée pour bénéficier d'un bon facteur de suréchantillonnage qui est nécessaire au codage sigma-delta. Cette contrainte n'est pas forcément gênante dans l'architecture du dispositif émetteur puisqu'il est habituel d'utiliser une fréquence d'échantillonnage élevée dans le DAC d'émission pour ne pas contraindre trop le filtre analogique suivant ce même DAC. Dans l'approche proposée par Boo et al., il est montré que l'utilisation du codeur sigma-delta en amont du DAC permet également de simplifier l'implémentation de la prédistorsion en évitant d'avoir besoin d'inverser la fonction de transfert de l'amplificateur. Elle permet d'utiliser une simple look-up table pour modéliser le comportement non linéaire du DAC permettant de compenser celui du PA. L'inconvénient principal de cette architecture est que le bruit de quantification dû au codage sigma-delta, dont la puissance augmente en fonction de la fréquence dès la fin de la bande passante du signal, doit être filtré par un filtre analogique avec une faible fréquence de coupure, ce qui apporte des contraintes fortes sur le filtre analogique. De plus, dans l'exemple considéré, il n'y a pas de prédistorsion effectivement mise en place pour l'amplificateur. Dans le cas où l'on voudrait utiliser une prédistorsion, il faudrait potentiellement augmenter la bande passante du DAC et donc augmenter d'autant la fréquence d'échantillonnage pour garder un facteur de suréchantillonnage constant.

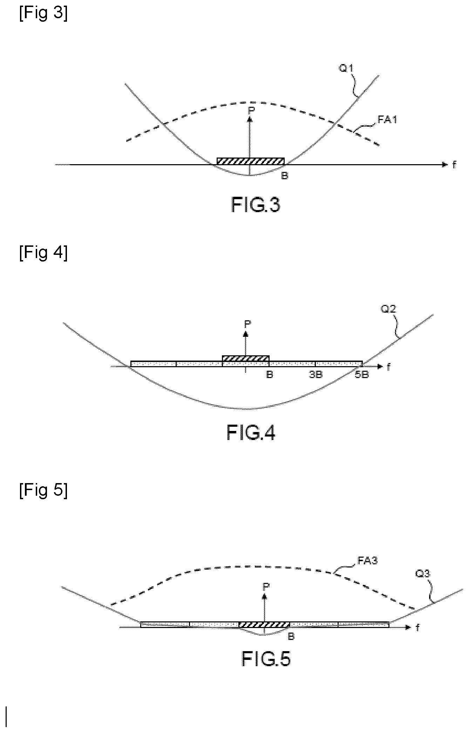

La Figure 3, illustre le spectre du bruit de quantification apporté par un codeur sigma delta quand il est positionné en amont du DAC dans un dispositif émetteur du type de la figure 1, comme évoqué plus haut, mais sans opération de prédistorsion. En hachuré figure le spectre du signal utile, la courbe Q1 représente le bruit de quantification généré par le codeur sigma-delta (faible dans la bande +B/-B), la courbe en tiret FA1 représente le filtrage analogique qui suit le DAC, qui comme dans l'exemple donné par Boo et al., élimine le bruit de quantification en dehors de la bande passante +B/-B.

Dans l'exemple de la Figure 4, la prédistorsion est mise en oeuvre, le bruit de non linéarité de l'amplificateur est représenté en pointillé : le bruit de quantification Q2 généré par le codeur sigma-delta doit être atténué dans une bande passante plus large, donc la fréquence d'échantillonnage requise va être plus élevée, ce qui est problématique lorsque la bande passante du signal d'entrée est importante.

US 2005/0110562 A1, Othmani Marouan et al: "Delta-Sigma Modulator-Embedded Digital Predistortion for 5G Transmitter Linearization" , IEEE Transactions on Communications, vol. 70, no. 8, pages 5558-5571, et US 2012/0269291 A1 exposent d'autres architectures et procédés de prédistortion.

**Résumé de l'invention :**

A cet effet, suivant un premier aspect, la présente invention décrit un dispositif émetteur comprenant N voies Vi, i = 1 à N $\geq$ 1, chacune desdites voies Vi comprenant :

- une voie de traitement d'émission adaptée pour traiter un signal d'entrée et comprenant un bloc de prédistorsion, un convertisseur numérique-analogique, un premier filtre analogique et un amplificateur de puissance, ledit dispositif émetteur comprenant un dispositif transducteur couplé à ladite voie de traitement et recevant le signal d'entrée une fois traité par ladite voie de traitement, le bloc de prédistorsion étant adapté pour appliquer une prédistorsion audit signal d'entrée, en fonction de coefficients de prédistorsion, pour compenser les non-linéarités de l'amplificateur de puissance ;
- une voie de retour associée à la voie de traitement d'émission, adaptée pour recevoir le signal traité par la voie de traitement et comprenant un deuxième filtre analogique, un convertisseur analogique-numérique, et un bloc d'estimation de coefficients de pré-distorsion, ledit bloc d'estimation de coefficients de prédistorsion étant adapté pour estimer, en fonction d'au moins ledit signal d'entrée et d'un signal, dit signal de retour, obtenu suite au moins aux opérations successives, sur le signal traité reçu, de filtrage par le deuxième filtre et de conversion par le convertisseur analogique-numérique, des coefficients de pré-distorsion et pour délivrer lesdits coefficients de prédistorsion estimés au bloc de prédistorsion ;

dans lequel la voie de traitement comporte en outre un codeur sigma-delta entre le bloc de prédistorsion et le convertisseur numérique-analogique, adapté pour effectuer notamment une quantification ;

ledit dispositif émetteur étant caractérisé en ce que le bloc d'estimation de coefficients de prédistorsion est adapté pour estimer lesdits coefficients de pré-distorsion en fonction d'au moins ledit signal d'entrée et d'un signal résultant de la soustraction, audit signal de retour, d'un signal représentant le bruit de quantification résultant de la quantification effectuée par le codeur sigma-delta.

L'invention propose ainsi d'annuler le bruit de quantification généré par un codeur sigma delta disposé en amont du DAC dans les bandes en-dehors la bande B/-B du signal utile d'entrée (de B à 5B dans l'exemple mentionné plus haut avec r= 5 ou au-dela en fonction de la prédistorsion) au niveau de la boucle de retour. Ainsi, une fréquence d'échantillonnage modérée du DAC peut être conservée.

Dans des modes de réalisation, un tel dispositif comprendra en outre l'une au moins des caractéristiques suivantes :

- ledit signal représentant le bruit de quantification est fonction dudit bruit de quantification mis en forme par la fonction de transfert NTF(z) de bruit du codeur sigma-delta ;

- le dispositif émetteur sans fil est adapté pour obtenir ledit signal représentant le bruit de quantification en effectuant au moins l'une desdites opérations parmi :

  - un filtrage et une décimation pour adapter la fréquence d'échantillonnage et la bande passante du signal représentant le bruit de quantification au signal d'entrée

  - un filtrage pour reproduire au moins l'effet des premier et deuxième filtres ;

  - un filtrage de type FIR pour reproduire l'effet des premier et deuxième filtres, la fonction de transfert dudit filtrage FIR étant estimée en fonction de la comparaison entre ledit signal de retour et un signal obtenu à partir du bruit de quantification extrait du codeur sigma-delta ;

N >1 ;

- la taille de chemins de données dans le bloc d'estimation de coefficients de prédistorsion dans chaque voie est surdimensionnée, pour introduire des non-linéarités additionnelles ; et/ou

- le dispositif émetteur comprend un bloc de contrôle adapté pour, dans une phase transitoire préalable, déclencher la fourniture de signaux déterministes à l'entrée des convertisseurs numériques-analogiques, tels que étant donné deux voies distinctes quelconques, l'amplitude et/ou la fréquence de ces signaux déterministes est différente entre lesdites voies.

Suivant un autre aspect, l'invention décrit un procédé de prédistorsion dans un dispositif émetteur comprenant N voies Vi, i = 1 à N ≥ 1, chacune desdites voies Vi comprenant :

- une voie de traitement d'émission adaptée pour traiter un signal d'entrée et comprenant un bloc de prédistorsion, un convertisseur numérique-analogique, un premier filtre analogique et un amplificateur de puissance, ledit dispositif émetteur comprenant un dispositif transducteur couplé à ladite voie de traitement et recevant le signal d'entrée une fois traité par ladite voie de traitement, le bloc de prédistorsion étant adapté pour appliquer une prédistorsion audit signal d'entrée, en fonction de coefficients de pré-distorsion, pour compenser les non-linéarités de l'amplificateur de puissance ;

- une voie de retour associée à la voie de traitement d'émission, adaptée pour recevoir le signal traité par la voie de traitement et comprenant un deuxième filtre analogique, un convertisseur analogique-numérique, et un bloc d'estimation de coefficients de pré-distorsion ;

dans lequel la voie de traitement comporte en outre un codeur sigma-delta entre le bloc de prédistorsion et le convertisseur numérique-analogique, adapté pour effectuer notamment une quantification ;

ledit procédé comprenant une étape d'estimation des coefficients de pré-distorsion par ledit bloc d'estimation de coefficients de prédistorsion, en fonction d'au moins ledit signal d'entrée et d'un signal, dit signal de retour, obtenu suite au moins aux opérations successives, sur le signal traité reçu, de filtrage par le deuxième filtre et de conversion par le convertisseur analogique-numérique, lesdits coefficients de prédistorsion estimés étant délivrés au bloc de prédistorsion ;

ledit procédé étant caractérisé en ce que le bloc d'estimation de coefficients de prédistorsion (estime lesdits coefficients de pré-distorsion en fonction d'au moins ledit signal d'entrée et d'un signal résultant de la soustraction, audit signal de retour, d'un signal représentant le bruit de quantification résultant de la quantification effectuée par le codeur sigma-delta.

Dans des modes de réalisation, un tel procédé comprendra en outre l'une au moins des caractéristiques suivantes :

- ledit signal représentant le bruit de quantification est fonction dudit bruit de quantification mis en forme par la fonction de transfert NTF(z) de bruit du codeur sigma-delta ;

- ledit signal représentant le bruit de quantification est obtenu en effectuant au moins l'une desdites opérations parmi :

  - un filtrage et une décimation pour adapter la fréquence d'échantillonnage et la bande passante du signal représentant le bruit de quantification au signal d'entrée ;

  - un filtrage pour reproduire au moins l'effet des premier et deuxième filtres ;

  - un filtrage de type FIR pour reproduire l'effet des premier et deuxième filtres, la fonction de transfert dudit filtrage FIR étant estimée en fonction de la comparaison entre ledit signal de retour et un signal obtenu à partir du bruit de quantification extrait du codeur sigma-delta.

Suivant un autre aspect, l'invention décrit un procédé de décorrélation des bruits de quantification dans un dispositif émetteur, selon lequel un procédé de prédistorsion selon l'invention est mis en oeuvre sur chacune des voies Vi, i = 1 à N, avec N entier >1.
Dans des modes de réalisation, ce procédé comprend les étapes suivantes :

- la taille de chemins de données dans le bloc d'estimation de coefficients de prédistorsion dans chaque voie est surdimensionnée, pour introduire des non-linéarités additionnelles ; et/ou

- dans une phase transitoire préalable, des signaux déterministes sont fournis à l'entrée des convertisseurs numériques-analogiques, tels que étant donné deux voies distinctes quelconques, l'amplitude et/ou la fréquence de ces signaux déterministes est différente entre lesdites voies.

**Brève description des figures :**

L'invention sera mieux comprise et d'autres caractéristiques, détails et avantages apparaîtront mieux à la lecture de la description qui suit, donnée à titre non limitatif, et grâce aux figures annexées, données à titre d'exemple.

[Fig. 1] La figure 1 est une illustration d'une architecture d'un dispositif émetteur de l'art antérieur effectuant un traitement de prédistorsion ;

[Fig. 2] La figure 2 est une représentation schématique du spectre du signal en sortie de l'amplificateur de puissance dans un dispositif émetteur présentant une distorsion ;

[Fig. 3] La figure 3 est une représentation schématique du spectre du signal en sortie de l'amplificateur de puissance dans un dispositif émetteur comportant un codeur sigma-delta et un filtre de mise en forme du bruit sans distorsion ;

[Fig. 4] La figure 4 est une représentation schématique du spectre du signal en sortie de l'amplificateur de puissance dans un dispositif émetteur comportant un codeur sigma-delta et un filtre de mise en forme du bruit et effectuant un traitement de prédistorsion ;

[Fig. 5] La figure 5 est une représentation schématique du spectre du signal en sortie de l'amplificateur de puissance dans un dispositif émetteur comportant un codeur sigma-delta et un filtre de mise en forme du bruit et effectuant un traitement de prédistorsion dans un mode de réalisation de l'invention ;

[Fig. 6] La figure 6 est une illustration d'une architecture d'un dispositif émetteur effectuant un traitement de prédistorsion dans un mode de réalisation de l'invention ;

[Fig. 7] La figure 7 est une illustration d'un bloc d'estimation des coefficients de compensation dans un mode de réalisation de l'invention ;

[Fig. 8] La figure 8 illustre une partie d'un bloc d'estimation des coefficients de compensation dans un mode de réalisation de l'invention ;

[Fig. 9] La figure 9 est une illustration d'une architecture d'un dispositif émetteur effectuant un traitement de prédistorsion dans un mode de réalisation de l'invention ;

[Fig. 10] La figure 10 est une illustration des étapes d'un procédé dans un mode de réalisation de l'invention.

Des références identiques peuvent être utilisées dans des figures différentes lorsqu'elles désignent des éléments identiques ou comparables.

**Description détaillée :**

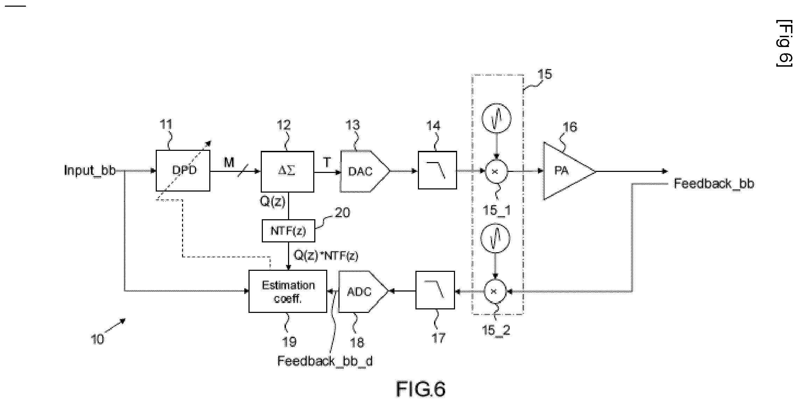

En figure 6, un schéma de principe d'un dispositif émetteur 10 est représenté dans un mode de réalisation de l'invention, dans un exemple non limitatif un dispositif émetteur de télécommunications sans fil, ici radiofréquence (on notera notamment que les éventuelles voies I/Q de signaux en quadrature ne sont pas représentées à des fins de clarté).
Le dispositif émetteur 10 comporte au moins une voie de traitement d'émission et une voie de retour associée à cette voie de traitement d'émission.
La voie de traitement d'émission comporte, de l'entrée vers la sortie de la voie de traitement d'émission, sur chacune des deux chaînes de traitement I, Q (une seule chaîne étant représentée) : un bloc de prédistorsion numérique (DPD) 11, un codeur sigma-delta 12, un convertisseur numérique analogique (DAC) 13, un filtre passe-bas 14, un étage de changement de fréquence (up-conversion) 15_1. La voie de traitement comporte ensuite, en aval des deux chaînes de traitement I , Q, un amplificateur de puissance (PA) 16. Elle est adaptée pour obtenir en sortie du PA le signal à émettre, destiné ici à une antenne RF.
La voie de retour associée à cette voie de traitement d'émission comprend, depuis son entrée vers sa sortie, un étage de changement de fréquence (down-conversion) 15_2, puis, sur chacune de deux chaînes parallèle de traitement I, Q (une seule chaîne étant représentée), un filtre passe-bas 17, un convertisseur analogique-numérique (ADC) 18. La voie de retour comporte enfin un bloc d'estimation des coefficients de prédistorsion 19, recevant en entrée, les sorties des ADC 18.

Le dispositif 10 comporte, dans le cas présent, un bloc de mise en forme du bruit 20, optionnel, disposé entre le codeur sigma-delta 12 et le bloc d'estimation 19 et auquel est appliqué le bruit de quantification du codeur sigma-delta 12.

La voie de retour est adaptée pour obtenir le signal en sortie du PA 16 et déterminer les coefficients de prédistorsion définissant la non-linéarité en fonction dudit signal en sortie du PA 16.

Le bloc 15 comprenant les étages de changement de fréquence 15_1 et 15_2 est lui aussi optionnel.

L'invention comprend la soustraction du bruit de quantification extrait du codeur sigma_delta 12 obtenu pour un signal numérique en entrée de la voie de traitement, nommé input_bb, au signal délivré en sortie du PA 16 pour ce même signal d'entrée input_bb, puis les non-linéarités du PA 16 en fonction de la puissance sont évaluées par le bloc d'estimation 19 en comparant le résultat de cette soustraction (i.e. le signal en sortie du PA 16 correspondant au signal d'entrée input_bb moins le bruit de quantification) et le signal d'entrée input_bb.

En annulant ainsi le bruit de quantification dans le bloc d'estimation 19, les contraintes vis-à-vis de la voie de traitement en émission en termes de bruit de quantification et de fréquence d'échantillonnage peuvent être réduites.

Le bloc DPD 11 est adapté pour effectuer une prédistorsion numérique sur un signal numérique qui lui est fourni en entrée, destinée à compenser les non-linéarités du PA 16 en numérique, en fonction de coefficients de prédistorsion calculés par le bloc d'estimation 19, par exemple en augmentant la puissance du signal en entrée pour les valeurs de puissance pour lesquels le PA 16 apporte une atténuation. Ainsi, les effets de non-linéarités du PA 16 seront réduits (moins de bruit dans la bande et en dehors de la bande) et il sera possible d'utiliser le PA 16 avec une puissance de sortie supérieure et donc on pourra ainsi améliorer l'efficacité énergétique

Les techniques mises en oeuvre sont diverses et connues de l'homme du métier : par exemple de type prédistorsion par LUT (Look-Up Table) ou par modèles mathématiques.

La LUT est une table mémoire qui fournit, pour une valeur de signal en entrée input_bb, une valeur correspondante en sortie en fonction de coefficients de prédistorsion, qu'elle contient, qui sont adaptés en fonction des distorsions générées par l'amplificateur 16.

La prédistorsion par modèles mathématiques s'appuie sur la modélisation mathématique des systèmes non-linéaires pour déterminer la caractéristique inverse de l'amplificateur. On connaît par exemple des modèles dérivés des séries de Volterra comme le modèle polynomial, les modèles de la famille Hammerstein-Wiener ou le modèle de NARMA etc. Des coefficients d'un modèle sont ainsi calculés en fonction des signaux d'entrée et de sortie de l'amplificateur, selon un critère de minimisation d'erreur.

Le codeur sigma-delta 12 est ici un codeur sigma-delta numérique-numérique qui reçoit un train de bits, avec une précision de M bits et délivre un train de bits avec une précision de T bits, avec T< M et M, T nombres entiers.

Un codeur sigma-delta 12 est, de façon connue, un dispositif à boucle de rétroaction effectuant un encodage sur un faible nombre de bits (par exemple, un ou deux ou inférieur à 5...), et une fréquence d'échantillonnage élevée par rapport à la bande passante du signal à encoder. Ce dispositif met en forme le spectre du bruit de quantification en repoussant sa puissance dans une bande de fréquence non occupée par le spectre du signal utile. Cette séparation spectrale permet, grâce à un filtrage du signal encodé, de conserver un rapport signal à bruit conforme à des spécifications données.

Le codeur sigma-delta 12 comprend, de façon générale :

une entrée pour recevoir un signal d'entrée numérique, codé sur M bits ;

une sortie pour délivrer une valeur numérique de sortie codée sur T bits, ici délivrée au DAC 13 ; et,

une ou plusieurs cellules sigma-delta disposées entre l'entrée et la sortie du codeur.

Chaque cellule peut être du premier ordre ou d'un ordre supérieur. Notamment, certaines peuvent être du premier ordre, et d'autres d'un ordre supérieur.

Chaque cellule sigma-delta comprend au minimum les éléments suivants :

un soustracteur comprenant une première entrée, une seconde entrée, et une sortie, la première entrée étant couplée à l'entrée du codeur pour recevoir le signal d'entrée ou une valeur dérivée de celle-ci ;

un intégrateur comprenant une entrée couplée à la sortie du soustracteur, et une sortie ; et,

un quantificateur ayant une entrée couplée à la sortie de l'intégrateur et une sortie couplée à la seconde entrée du soustracteur ; la sortie du quantificateur est, en outre, couplée à la sortie du codeur pour délivrer la valeur numérique de sortie ou une contribution à celle-ci.

Le codeur 12 est caractérisé par sa fonction de transfert, reliant son signal de sortie S_OUT à son signal d'entrée S_IN et au bruit de quantification Q et donc l'expression de la transformée en z est la suivante :

$$S\_OUT(z) = S\_IN.STF(z) + Q.NTF(z)$$

où STF est la fonction de transfert du signal d'entrée du codeur 12 (en anglais Signal Transfer Function) et NTF est la fonction de transfert de bruit du codeur 12 (en anglais Noise Transfer Function), exprimées ici en fonction de la fréquence ; Q est le bruit de quantification, égal à la différence entre la sortie du quantificateur et l'entrée du quantificateur.

La fonction de transfert de signal fonctionne avec un gain de 1 dans la bande passante d'intérêt. La fonction de transfert de bruit est une fonction de filtre passe-haut, fournissant la mise en forme du bruit : forte suppression du bruit de quantification dans les basses fréquences tandis que le bruit de quantification aux hautes fréquences en-dehors de la bande passante est accru.

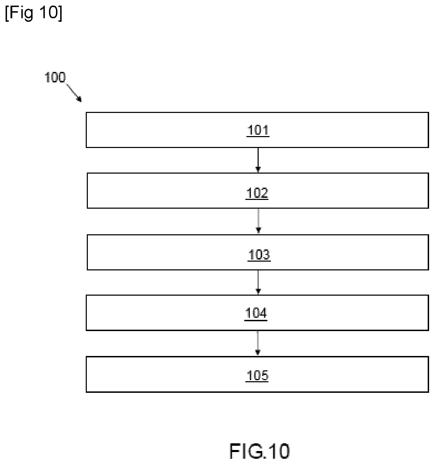

Les étapes d'un procédé de traitement 100 mises en oeuvre par un dispositif émetteur 10 dans un mode de réalisation sont maintenant décrites en référence à la figure 10. Elles sont réalisées par exemple dans une étape de calibration, qui peut par exemple avoir lieu préalablement à la phase opérationnelle et qui dans un mode de réalisation, utilise des signaux d'entrée prédéterminés.

Ainsi, dans une étape 101, les sous-étapes suivantes sont mises en oeuvre :

- 101_1 : un signal numérique d'entrée input_bb est fourni à l'instant $\tau$ en entrée du dispositif émetteur 10 ; le DPD 11 effectue une prédistorsion de ce signal, en fonction de coefficients de prédistorsion dernièrement fournis par le bloc d'estimation 19 (ou encore initialisés à une valeur prédéterminée, par exemple à zéro) ;

- 101_2 : le signal d'entrée ainsi prédistordu est fourni en entrée du codeur sigma-delta 12, qui réduit le nombre de bits de codage à T bits ; le signal résultant du traitement par le codeur sigma-delta 12 en sortie de ce dernier est fourni en entrée du DAC 13 ;

- 101_3 : le DAC 13 effectue une conversion en analogique de ce signal qui lui est fourni en entrée et délivre ce signal analogique en entrée du filtre analogique 14 ;

- 101_4 : le filtre 14 effectue un filtrage passe-bas du signal fourni en entrée et le délivre à l'étage de changement de fréquence 15_1 ;

- 101_5 : l'étage de changement de fréquence 15_1 transpose le signal qui lui a été fourni en entrée à la fréquence porteuse RF et délivre le signal transposé au PA 16 ;

- 101_6 : le PA 16 amplifie ce signal qui lui est fourni, avec des non-linéarités, et le fournit à l'antenne d'émission RF.

Dans une étape 102, qui par exemple est effectuée en parallèle des sous-étapes 101_3 à 101_6, le bruit de quantification (Q(z)) du codeur sigma-delta 12 est extrait (par exemple à l'aide d'un soustracteur, non représenté, calculant la différence entre l'entrée du codeur sigma-delta 12 et la sortie du codeur sigma-delta 12 reliée au DAC 13 considérées à l'étape 101_2). Optionnellement, ce bruit de quantification est ensuite multiplié, dans le bloc 20 de mise en forme du bruit, par la fonction de transfert de mise en forme de bruit NTZ(z) du codeur sigma-delta 12, pour obtenir Q(z)*NTF(z) qui est le bruit de quantification mis en forme (en variante, dans certains types de codeurs 12, Q(z)*NTF(z) est extrait directement). Le bloc 20, optionnellement, délivre une partie filtrée du bruit de quantification, i.e. Q(z)*H(z) ou Q(z)*H(z)*NTF(z), où H(z) est un filtre passe-bas ou passe-bande, ce qui permet de limiter la quantité de données qui transitent entre les blocs 12 et 19. Le bruit de quantification ainsi optionnellement filtré et/ou mis en forme est fourni au bloc d'estimation 19.

Dans une étape 103, les sous-étapes suivantes sont mises en oeuvre :

- 103_1 : le signal amplifié à l'issue de la sous-étape 101_6 ci-dessus est reçu en entrée de la voie de retour (par exemple via un coupleur couplant la sortie du PA 16 vers l'antenne et l'entrée de la voie de retour) ; le signal tel que reçu est appelé Feedback_bb ;

- 103_2 : le étage de changement de fréquence 15_2 transpose le signal Feedback_bb de la fréquence porteuse RF en bande de base et délivre le signal transposé au filtre 17 ;

- 103_3 : le filtre 17 filtre le signal transposé (il supprime les hautes fréquences) et délivre le signal filtré à l'ADC 18 ;

- 103_4 : l'ADC 18 convertit en numérique le signal qui lui est fourni en entrée et délivre le signal numérique résultant Feedback_bb_d au bloc d'estimation 19.

Dans une étape 104, le bloc d'estimation 19 estime les coefficients de prédistorsion en fonction du signal input_bb considéré à l'étape 101, du signal obtenu à l'étape 103_4 délivré par l'ADC 18 et du signal Q(z)*NTF(z) (ou Q(z)*H(z)*NTF(z) ou Q(z)*H(z) ou Q(z)) fourni au bloc d'estimation à l'étape 102. Les coefficients de prédistorsion estimés sont fournis au bloc DPD 11.

Dans un mode de réalisation, les étapes du procédé 100 sont itérées cycliquement après une phase d'initialisation, les coefficients de prédistorsion utilisés par le bloc DPD 11 étant ainsi cycliquement mis à jour ; dans un autre mode de réalisation, elles sont mises en oeuvre uniquement lors d'une phase préliminaire de calibration.

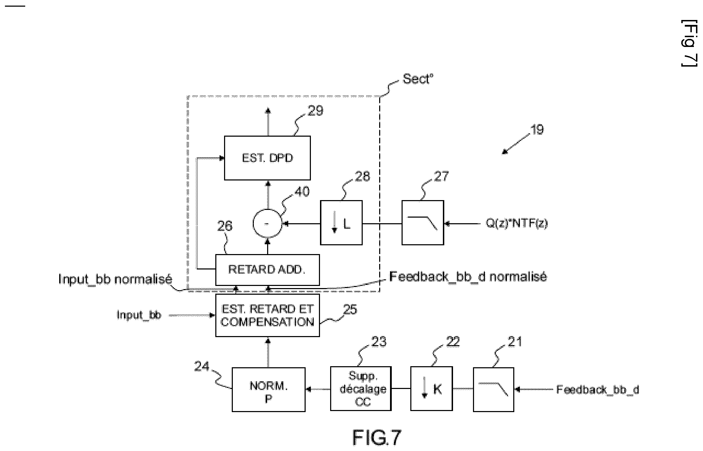

La figure 7 représente un schéma du bloc d'estimation 19 dans un mode de réalisation.

De façon facultative, un filtre 21 filtre le signal Feedback_bb_d et ensuite un décimateur 22 sous-échantillonne d'un facteur K le signal Feedback_bb_d filtré : ceci permet de se ramener à une fréquence d'échantillonnage similaire au signal en bande de base. Facultativement aussi, un bloc de suppression 23 élimine la composante continue (DC offset du signal qui peut être important).

Ensuite un bloc de normalisation 24 normalise la puissance du signal qui lui est fourni par le bloc de suppression 23 : en effet, il est nécessaire que lorsque l'on compare ensuite le signal de référence (signal d'entrée en bande de base input_bb) et le signal émis (signal de feedback Feddback_bb_d), ceux-ci aient la même puissance. Un bloc d'estimation de retard et de compensation 25 compense le retard entre le signal d'entrée et le signal de feedback : en effet, le signal de feedback ayant traversé la voie d'émission et la voie de retour est retardé par rapport au signal d'entrée input_bb considéré à l'instant $\tau$ et dont il résulte : il doit donc être resynchronisé sur le signal d'entrée pour être en mesure de faire une comparaison plus pertinente. A l'issue de ces traitements, le bloc d'estimation de retard et de compensation 25 délivre les signaux « ilnput_bb normalisé » et « feedback_bb normalisé »

Un bloc de détermination de retard additionnel 26 a pour but de déterminer le décalage de temps à appliquer entre ces signaux et le signal représentatif du bruit de quantification délivré par le bloc de mise en forme de bruit 20 pour les resynchroniser entre eux (i.e qu'ils résultent tous du signal d'entré input_bb considéré à l'instant $\tau$ ). Cette prise en compte (optionnelle) rend plus pertinente l'estimation des coefficients de prédistorsion ensuite effectuée par le bloc 19.

Des opérations sont par exemple appliquées à ce bruit de quantification Q(z)*NTF(z) (ou Q(z)*H(z)*NTF(z) ou Q(z)*H(z) ou Q(z)) avant qu'on ne le soustraie au signal issu du signal de retour : il est filtré par un filtre passe-bas 27, puis sous-échantillonné d'un facteur L par un décimateur 28 : ceci a pour but d'adapter la fréquence d'échantillonnage et la bande passante du bruit de quantification au besoin, notamment au signal en bande de base. Il est possible en outre de filtrer le bruit de quantification pour reproduire l'influence du filtre analogique 14 qui se trouve dans la voie de traitement d'émission ainsi que le filtre analogique 17 qui se trouve dans la voie de retour. On pourra aussi utiliser un filtre 27 passe-bande plutôt que passe-bas.

Un soustracteur 40 soustrait du signal de retour Feedback_bb_normalisé (et synchronisé) le signal représentant le bruit de quantification après ces filtrages et décimation le cas échéant. Et un sous-bloc 29 d'estimation des coefficients calcule alors les coefficients de prédistorsion, de façon connue, pour compenser les variations de gain de l'amplificateur selon la puissance du signal en entrée, en fonction des signaux input_bb normalisé et synchronisé et du signal résultant de la soustraction, par exemple en les comparant.

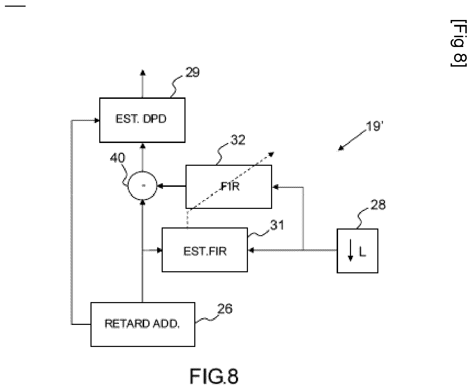

Dans un mode de réalisation, la section Sect du bloc d'estimation 19 en figure 7 est remplacée, dans un autre mode de réalisation, par le contenu de la figure 8. Les éléments similaires entre les deux figures ont les mêmes numéros de référence. Ce mode de réalisation permet de prendre en compte plus précisément l'influence (et ses variations dans le temps) des fonctions de transferts implémentées en analogique, par exemple du filtre passe bas 14 suivant le DAC 13 et, dans la voie de retour, (dans une moindre mesure) du filtre 17 précédant l'ADC 18, qui peuvent avoir une influence sur le spectre du bruit de quantification tel qu'il se retrouve dans le signal de retour.

Dans un mode de réalisation, la modélisation de ces fonctions de transfert est réalisée par un filtre numérique, à réponse impulsionnelle finie 32 (FIR pour « Finite Impulse Response » en anglais) et la fonction de transfert de ce filtre est estimée par un bloc d'estimation FIR 31 qui évalue les coefficients de cette fonction de transfert réelle en comparant le signal reçu par la voie de retour et le bruit de quantification, isolé par extraction depuis le codeur sigma-delta.

L'opération d'annulation du bruit de quantification est effectuée dans le bloc d'estimation 19, dans l'exemple détaillé ci-dessus, parce qu'elle comprend une normalisation de la puissance des signaux et une compensation de délai ; mais elle peut à la place être effectuée en dehors de ce bloc 19.

Sur la figure 5 sont représentés :

- le spectre (en hachuré) du signal d'entrée du dispositif émetteur dans le mode de réalisation considéré de l'invention occupant +B/-B,

- le spectre Q3 du bruit de quantification comme il va apparaître dans le bloc d'estimation des coefficients 19 après annulation du bruit de quantification dans la bande +/-5B,

- le filtrage analogique FA3 par le filtre 14 disposé après le DAC 13,

- le bruit de non-linéarité due à l'amplificateur 16, en pointillé.

Le codeur sigma-delta a le même comportement que dans le cas de la figure 3, mais dans la bande passante, le bruit de quantification est annulé pour accéder au signal d'intermodulation présent dans la bande de B à 5B.

Ainsi, dans un dispositif émetteur selon l'invention, la même fréquence d'échantillonnage que considérée dans le cas de la figure 3 peut être conservée même si une prédistorsion est effectuée.

## DECORRELATION

Une des effets d'intégrer le codeur sigma delta dans la voie de traitement en émission, comme décrit ci-dessus, est de réduire le nombre de bits en entrée du DAC 13, ce qui est particulièrement critique dans les dispositifs émetteurs multivoies.

De plus, l'invention proposée permet de réduire les contraintes de fréquence de suréchantillonnage, ce qui est particulièrement critique dans les systèmes millimétriques. De plus, ces systèmes ont généralement des contraintes de bruit dans les canaux adjacents moins importantes. Cela s'adapte donc plus particulièrement à l'invention proposée puisqu'une partie du bruit de quantification est émis dans les bandes de B à 5B et est émis dans le spectre, ce qui vient polluer les canaux adjacents. Dans le cas des systèmes millimétriques, les contraintes de bruit dans les canaux adjacents sont généralement moins sévères.

Il est souvent nécessaire, dans les architectures de dispositif émetteur utilisées par exemple pour effectuer du beamforming numérique, d'avoir un grand nombre de ces voies en parallèle afin d'obtenir un gain important dans la direction visée. Ce grand nombre de voies entraîne une surface de silicium importante et peut entraîner un nombre d'entrée/sortie importante. Pour limiter le nombre d'entrée/sortie, il est possible d'utiliser le même signal numérique en entrée de toutes les voies (I, respectivement Q) et d'effectuer le beamforming en opérant un retard différent (et/ou en opérant un déphasage des signaux) sur chacune des voies, pour compenser la différence de temps de vol entre les signaux.

Dans le cas des architectures multivoies, l'utilisation de codeur sigma delta tel que proposé en figure 6 peut s'avérer problématique puisque si le signal d'entrée est le même sur chacune des voies de traitement d'émission, alors le bruit de quantification sera le même sur chacune des voies et va donc s'ajouter de façon cohérente lors de la formation du faisceau, ce qui augmente le bruit dans la bande et en dehors de la bande. Dans ce but, WO2020105040A1 propose d'implémenter les modulateurs sigma-delta de façon différentiée les uns des autres afin de réduire la corrélation du bruit entre les différentes voies.

L'implémentation de la prédistorsion dans chacune des voies d'un dispositif émetteur comprenant N voies Vi, i = 1 à N (N entier strictement supérieur à 1) comprenant chacune une voie de traitement d'émission et une voie de retour telles que considérées plus haut contribue à résoudre le problème de corrélation des bruits de quantification. En effet, il est fort probable que les coefficients des différents amplificateurs de puissance soient différents les uns des autres ce qui en soi va rendre les signaux d'entrée différents les uns des autres et va donc décorréler les bruits de quantification.

Dans un mode de réalisation, un tel dispositif émetteur multivoies comporte en outre un bloc de contrôle (non représenté) mettant en oeuvre des traitements pour :

(i) garantir que les bruits soient décorrélés avant l'activation de la prédistorsion ; et/ou

(ii) s'assurer que les ensembles de coefficients de prédistorsion utilisés par les DPD à un même instant dans deux voies différentes Vi, Vj, i #j, restentnt bien différents.

Une des solutions est de sur-dimensionner la taille des chemins de données dans les circuits de prédistorsion (i.e. le nombre de bits de codage des coefficients de la fonction non linéaire de prédistorsion et les calculs associés, un nombre B >0 de bits déterminés prenant ainsi, du fait du surdimensionnement, toujours la valeur numérique 0 et donnant lieu ensuite à des erreurs de mesure en analogique). Ainsi, il sera possible dans la première phase avant estimation initiale des paramètres de non-linéarités des PA, notamment avant calibration, de générer des erreurs de linéarités en dessous des niveaux qui dégradent les performances du dispositif émetteur. Ces valeurs seront différentes pour chacune des voies et permettront ainsi de décorréler les bruits de quantification. Cela permettra également d'augmenter la probabilité d'avoir des coefficients différents pour chacun des voies ou de permettre de les modifier légèrement en cas d'égalité sans que cela ait un impact sur les performances de linéarité. Ceci permettra d'éviter de modifier les codeurs sigma delta sur chacune des voies, ces codeurs resteront donc très simples et identiques sur toutes les voies.

Une autre alternative est d'envoyer des signaux déterministes à l'entrée des modulateurs sigma-delta à des niveaux faibles et à des fréquences telles que ces signaux soient filtrés par le filtre passe analogique utilisé dans l'émetteur, de telle sorte que ces signaux n'apparaissent pas en sortie du PA 16. On pourra faire varier simplement l'amplitude ou la fréquence des ces signaux entre les différentes voies. Ces signaux pourront être des simples signaux carrés qui sont simples à générer. En dernier lieu on pourra également s'assurer qu'après beam-forming, ces signaux déterministes s'annulent dans la direction d'émission visée. De tels signaux déterministes sont aisés à générer, hors bande (et donc supprimés) et ils ne sont utilisés que pendant la phase initiale, avant estimation des coefficients de distorsion de signaux en phase opérationnelle.

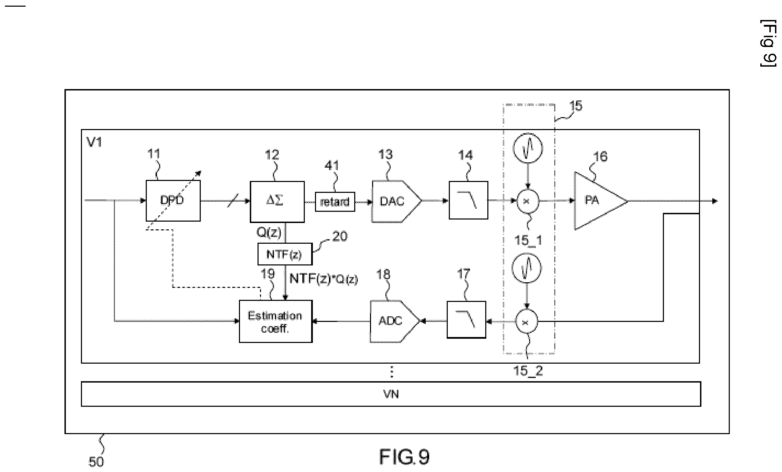

La figure 9 représente un dispositif émetteur 50 du type le dispositif émetteur 10 représenté en figure 6, comportant N voies V1, ... VN, chaque voie Vi comportant une voie de traitement d'émission et une voie de retour comme décrit en référence à la figure 6. Un bloc de retard 41 est en outre inséré entre le codeur sigma-delta 12 et le DAC 13. Une partie de ce retard peut également être implémenté au niveau du DAC 13. Ce retard permet d'effectuer l'opération de beamforming de façon plus efficace qu'avec un déphasage. Grâce à la nature digitale du signal, l'implémentation de ce retard est grandement simplifiée.

L'invention a été décrite ci-dessus dans un contexte d'émission radiofréquence, toutefois l'invention peut bien sûr être mise en oeuvre relativement à des dispositifs émetteurs autres, par exemple de signaux audiofréquence, ultrasons ...

## Revendications

1. Dispositif émetteur (10 ; 50) comprenant N voies Vi, i = 1 à N ≥ 1, chacune desdites voies Vi comprenant :

   - une voie de traitement d'émission adaptée pour traiter un signal d'entrée et comprenant un bloc de prédistorsion (11), un convertisseur numérique-analogique (13), un premier filtre analogique (14) et un amplificateur de puissance (16), ledit dispositif émetteur comprenant un dispositif transducteur couplé à ladite voie de traitement et recevant le signal d'entrée une fois traité par ladite voie de traitement, le bloc de prédistorsion (11) étant adapté pour appliquer une prédistorsion audit signal d'entrée, en fonction de coefficients de prédistorsion, pour compenser les non-linéarités de l'amplificateur de puissance ;
   - une voie de retour associée à la voie de traitement d'émission, adaptée pour recevoir le signal traité par la voie de traitement et comprenant un deuxième filtre analogique (17), un convertisseur analogique-numérique (18), et un bloc d'estimation de coefficients de pré-distorsion (19), ledit bloc d'estimation de coefficients de prédistorsion (19) étant adapté pour estimer, en fonction d'au moins ledit signal d'entrée et d'un signal, dit signal de retour, obtenu suite au moins aux opérations successives, sur le signal traité reçu, de filtrage par le deuxième filtre et de conversion par le convertisseur analogique-numérique, des coefficients de pré-distorsion et pour délivrer lesdits coefficients de prédistorsion estimés au bloc de prédistorsion ;
   dans lequel la voie de traitement comporte en outre un codeur sigma-delta (12) entre le bloc de prédistorsion et le convertisseur numérique-analogique, adapté pour effectuer notamment une quantification ;
   ledit dispositif émetteur (10 ; 50) étant **caractérisé en ce que** le bloc d'estimation de coefficients de prédistorsion (19) est adapté pour estimer lesdits coefficients de pré-distorsion en fonction d'au moins ledit signal d'entrée et d'un signal résultant de la soustraction, audit signal de retour, d'un signal représentant le bruit de quantification résultant de la quantification effectuée par le codeur sigma-delta (12).

2. Dispositif émetteur sans fil (10 ; 50) selon la revendication 1, dans lequel ledit signal représentant le bruit de quantification est fonction dudit bruit de quantification mis en forme par la fonction de transfert NTF(z) de bruit du codeur sigma-delta.

3. Dispositif émetteur sans fil (10 ; 50) selon la revendication 1 ou 2, adapté pour obtenir ledit signal représentant le bruit de quantification en effectuant au moins l'une desdites opérations parmi :

   - un filtrage et une décimation pour adapter la fréquence d'échantillonnage et la bande passante du signal représentant le bruit de quantification au signal d'entrée ;
   - un filtrage pour reproduire au moins l'effet des premier et deuxième filtres ;
   - un filtrage de type FIR pour reproduire l'effet des premier et deuxième filtres, la fonction de transfert dudit filtrage FIR étant estimée en fonction de la comparaison entre ledit signal de retour et un signal obtenu à partir du bruit de quantification extrait du codeur sigma-delta.

4. Dispositif émetteur (50) selon l'une des revendications précédentes, dans lequel N >1.

5. Dispositif émetteur (50) selon la revendication 4, dans lequel une taille de chemins de données dans le bloc d'estimation de coefficients de prédistorsion (19) dans chaque voie est surdimensionnée, pour introduire des non-linéarités additionnelles ; et/ou le dispositif émetteur comprend un bloc de contrôle adapté pour, dans une phase transitoire préalable, déclencher la fourniture de signaux déterministes à l'entrée des convertisseurs numériques-analogiques (13), tels que étant donné deux voies distinctes quelconques, l'amplitude et/ou la fréquence de ces signaux déterministes est différente entre lesdites voies.

6. Procédé de prédistorsion dans un dispositif émetteur (10 ; 50) comprenant N voies Vi, i = 1 à N ≥ 1, chacune desdites voies Vi comprenant :

   - une voie de traitement d'émission adaptée pour traiter un signal d'entrée et comprenant un bloc de prédistorsion (11), un convertisseur numérique-analogique (13), un premier filtre analogique (14) et un amplificateur de puissance (16), ledit dispositif émetteur comprenant un dispositif transducteur couplé à ladite voie de traitement et recevant le signal d'entrée une fois traité par ladite voie de traitement, le bloc de prédistorsion (11) étant adapté pour appliquer une prédistorsion audit signal d'entrée, en fonction de coefficients de prédistorsion, pour compenser les non-linéarités de l'amplificateur de puissance ;
- une voie de retour associée à la voie de traitement d'émission, adaptée pour recevoir le signal traité par la voie de traitement et comprenant un deuxième filtre analogique (17), un convertisseur analogique-numérique (18), et un bloc d'estimation de coefficients de pré-distorsion (19) ;
dans lequel la voie de traitement comporte en outre un codeur sigma-delta (12) entre le bloc de prédistorsion et le convertisseur numérique-analogique, adapté pour effectuer notamment une quantification ;
ledit procédé comprenant une étape d'estimation des coefficients de pré-distorsion par ledit bloc d'estimation de coefficients de prédistorsion (19), en fonction d'au moins ledit signal d'entrée et d'un signal, dit signal de retour, obtenu suite au moins aux opérations successives, sur le signal traité reçu, de filtrage par le deuxième filtre et de conversion par le convertisseur analogique-numérique, lesdits coefficients de prédistorsion estimés étant délivrés au bloc de prédistorsion ;
ledit procédé étant **caractérisé en ce que** le bloc d'estimation de coefficients de prédistorsion (19) estime lesdits coefficients de pré-distorsion en fonction d'au moins ledit signal d'entrée et d'un signal résultant de la soustraction, audit signal de retour, d'un signal représentant le bruit de quantification résultant de la quantification effectuée par le codeur sigma-delta (12).

7. Procédé de prédistorsion dans un dispositif émetteur (10 ; 50) selon la revendication 6, selon lequel ledit signal représentant le bruit de quantification est fonction dudit bruit de quantification mis en forme par la fonction de transfert NTF(z) de bruit du codeur sigma-delta

8. Procédé de prédistorsion dans un dispositif émetteur (10 ; 50) selon l'une des revendications 6 à 7, selon lequel ledit signal représentant le bruit de quantification est obtenu en effectuant au moins l'une desdites opérations parmi :

- un filtrage et une décimation pour adapter la fréquence d'échantillonnage et la bande passante du signal représentant le bruit de quantification au signal d'entrée ;
- un filtrage pour reproduire au moins l'effet des premier et deuxième filtres ;
- un filtrage de type FIR pour reproduire l'effet des premier et deuxième filtres, la fonction de transfert dudit filtrage FIR étant estimée en fonction de la comparaison entre ledit signal de retour et un signal obtenu à partir du bruit de quantification extrait du codeur sigma-delta.

9. Procédé de décorrélation des bruits de quantification dans un dispositif émetteur (50), selon lequel un procédé de prédistorsion selon les revendications 6 à 8 est mis en oeuvre sur chacune des voies Vi, i = 1 à N, avec N entier >1.

10. Procédé de décorrélation des bruits de quantification dans un dispositif émetteur selon la revendication 9, comprenant les étapes suivantes :

une taille de chemins de données dans le bloc d'estimation de coefficients de prédistorsion (19) dans chaque voie est surdimensionnée, pour introduire des non-linéarités additionnelles ; et/ou
dans une phase transitoire préalable, des signaux déterministes sont fournis à l'entrée des convertisseurs numériques-analogiques (13), tels que étant donné deux voies distinctes quelconques, l'amplitude et/ou la fréquence de ces signaux déterministes est différente entre lesdites voies.

**Patentansprüche**

1. Sendervorrichtung (10; 50) umfassend N Kanäle Vi, i = 1 bis N ≥ 1, wobei jeder der Kanäle Vi Folgendes umfasst:

- einen Sendeverarbeitungskanal, angepasst zum Verarbeiten eines Eingangssignals und umfassend einen Vorverzerrungsblock (11), einen Digital-Analog-Umsetzer (13), einen ersten Analogfilter (14) und einen Leistungsverstärker (16), wobei die Sendervorrichtung eine mit dem Verarbeitungskanal gekoppelte Wandlervorrichtung umfasst und das Eingangssignal empfängt, nachdem es von dem Verarbeitungskanal verarbeitet wurde, wobei der Vorverzerrungsblock (11) angepasst ist zum Anwenden einer Vorverzerrung auf das Eingangssignal, in Abhängigkeit von Vorverzerrungskoeffizienten, um die Nichtlinearitäten des Leistungsverstärkers zu kompensieren;
- einen dem Sendeverarbeitungskanal zugeordneten Rückkanal, angepasst zum Empfangen des von dem Verarbeitungskanal verarbeiteten Signals und umfassend einen zweiten Analogfilter (17), einen Analog-Digital-Umsetzer (18) und einen Block zum Schätzen von Vorverzerrungskoeffizienten (19), wobei der Block zum Schätzen von Vorverzerrungskoeffizienten (19) angepasst ist zum Schätzen, in Abhängigkeit von mindestens dem Eingangssignal und von einem als Rücksignal bezeichneten Signal, das infolge mindestens der aufeinanderfolgenden Vorgänge, auf dem empfangenen verarbeiteten Signal, des Filterns durch den zweiten Filter und des Umsetzens durch den Analog-Digital-Umsetzer erhalten wird, der Vorverzerrungskoeffizienten und zum Liefern der geschätzten Vorverzerrungskoeffizienten an den Vorverzerrungsblock;

wobei der Verarbeitungskanal ferner einen Sigma-Delta-Codierer (12) zwischen dem Vorverzerrungsblock und dem Digital-Analog-Umsetzer aufweist, der zum Durchführen insbesondere einer Quantisierung angepasst ist;

wobei die Sendervorrichtung (10; 50) **dadurch gekennzeichnet ist, dass** der Block zum Schätzen von Vorverzerrungskoeffizienten (19) angepasst ist zum Schätzen der Vorverzerrungskoeffizienten in Abhängigkeit von mindestens dem Eingangssignal und von einem Signal, das sich aus der Subtraktion ergibt, von dem Rücksignal, eines Signals, das das Quantisierungsgeräusch darstellt, das sich aus der durch den Sigma-Delta-Codierer (12) durchgeführten Quantisierung ergibt.

2. Kabellose Sendervorrichtung (10; 50) nach Anspruch 1, wobei das Signal, das das Quantisierungsgeräusch darstellt, abhängig ist von dem Quantisierungsgeräusch, das von der Geräuschübertragungsfunktion NTF(z) des Sigma-Delta-Codierers gebildet wird.

3. Kabellose Sendervorrichtung (10; 50) nach Anspruch 1 oder 2, angepasst zum Erhalten des Signals, das das Quantisierungsgeräusch darstellt, durch das Durchführen von mindestens einem der folgenden Vorgänge:

   - eine Filterung und eine Dezimierung zum Anpassen der Abtastfrequenz und der Bandbreite des Signals, das das Quantisierungsgeräusch darstellt, an das Eingangs signal;
   - eine Filterung zum Reproduzieren von mindestens dem Effekt des ersten und zweiten Filters;
   - eine Filterung vom Typ FIR zum Reproduzieren des Effekts des ersten und zweiten Filters, wobei die Übertragungsfunktion der FIR-Filterung in Abhängigkeit von dem Vergleich zwischen dem Rücksignal und einem Signal, das durch das aus dem Sigma-Delta-Codierer gewonnene Quantisierungsgeräusch erhalten wird, geschätzt wird.

4. Sendervorrichtung (50) nach einem der vorhergehenden Ansprüche, wobei N > 1.

5. Sendervorrichtung (50) nach Anspruch 4, wobei eine Größe von Datenpfaden im Block zum Schätzen von Vorverzerrungskoeffizienten (19) in jedem Kanal überdimensioniert ist, um zusätzliche Nonlinearitäten einzuführen; und/oder
   die Sendervorrichtung umfasst einen Kontrollblock, der, in einer vorherigen Übergangsphase, angepasst ist zum Auslösen des Bereitstellens von deterministischen Signalen am Eingang der Digital-Analog-Umsetzer (13), sodass, bei zwei beliebigen verschiedenen Kanälen, die Amplitude und/oder die Frequenz dieser deterministischen Signale zwischen den Kanälen unterschiedlich ist.

6. Verfahren zum Vorverzerren in einer Sendervorrichtung (10; 50), umfassend N Kanäle Vi, i = 1 bis N ≥ 1, wobei jeder der Kanäle Vi Folgendes umfasst:

   - einen Sendeverarbeitungskanal, angepasst zum Verarbeiten eines Eingangssignals und umfassend einen Vorverzerrungsblock (11), einen Digital-Analog-Umsetzer (13), einen ersten Analogfilter (14) und einen Leistungsverstärker (16), wobei die Sendervorrichtung eine mit dem Verarbeitungskanal gekoppelte Wandlervorrichtung umfasst und das Eingangssignal empfängt, nachdem es von dem Verarbeitungskanal verarbeitet wurde, wobei der Vorverzerrungsblock (11) angepasst ist zum Anwenden einer Vorverzerrung auf das Eingangssignal, in Abhängigkeit von Vorverzerrungskoeffizienten, um die Nichtlinearitäten des Leistungsverstärkers zu kompensieren;
   - einen dem Sendeverarbeitungskanal zugeordneten Rückkanal, angepasst zum Empfangen des von dem Verarbeitungskanal verarbeiteten Signals und umfassend einen zweiten Analogfilter (17), einen Analog-Digital-Umsetzer (18) und einen Block zum Schätzen von Vorverzerrungskoeffizienten (19);
   wobei der Verarbeitungskanal ferner einen Sigma-Delta-Codierer (12) zwischen dem Vorverzerrungsblock und dem Digital-Analog-Umsetzer aufweist, der zum Durchführen insbesondere einer Quantisierung angepasst ist;
   wobei das Verfahren einen Schritt des Schätzens von Vorverzerrungskoeffizienten durch den Block zum Schätzen von Vorverzerrungskoeffizienten (19) umfasst, in Abhängigkeit von mindestens dem Eingangssignal und von einem als Rücksignal bezeichneten Signal, das infolge mindestens der aufeinanderfolgenden Vorgänge, auf dem empfangenen verarbeiteten Signal, des Filterns durch den zweiten Filter und des Umsetzens durch den Analog-Digital-Umsetzer erhalten wird, wobei die geschätzten Vorverzerrungskoeffizienten an den Vorverzerrungsblock geliefert werden;

wobei das Verfahren **dadurch gekennzeichnet ist, dass** der Block zum Schätzen von Vorverzerrungskoeffizienten (19) die Vorverzerrungskoeffizienten schätzt in Abhängigkeit von mindestens dem Eingangssignal und von einem Signal, das sich aus der Subtraktion ergibt, von dem Rücksignal, eines Signals, das das Quantisierungsgeräusch darstellt, das sich aus der durch den Sigma-Delta-Codierer (12) durchgeführten Quantisierung ergibt.

7. Verfahren zum Vorverzerren in einer Sendervorrichtung (10; 50) nach Anspruch 6, gemäß dem das Signal, das das Quantisierungsgeräusch darstellt, abhängig ist von dem Quantisierungsgeräusch, das von der Geräuschübertragungsfunktion NTF(z) des Sigma-Delta-Codierers gebildet wird.

8. Verfahren zum Vorverzerren in einer Sendervorrichtung (10; 50) nach einem der Ansprüche 6 bis 7, gemäß dem das Signal, das das Quantisierungsgeräusch darstellt, durch Durchführen mindestens eines der folgenden Vorgänge erhalten wird:

   - eine Filterung und eine Dezimierung zum Anpassen der Abtastfrequenz und der Bandbreite des Signals, das das Quantisierungsgeräusch darstellt, an das Eingangs signal;
   - eine Filterung zum Reproduzieren von mindestens dem Effekt des ersten und zweiten Filters;
   - eine Filterung vom Typ FIR zum Reproduzieren des Effekts des ersten und zweiten Filters, wobei die Übertragungsfunktion der FIR-Filterung in Abhängigkeit von dem Vergleich zwischen dem Rücksignal und einem Signal, das durch das aus dem Sigma-Delta-Codierer gewonnene Quantisierungsgeräusch erhalten wird, geschätzt wird.

9. Verfahren zum Dekorrelieren von Quantisierungsgeräuschen in einer Sendervorrichtung (50), gemäß dem ein Vorverzerrungsverfahren nach den Ansprüchen 6 bis 8 auf jedem der Kanäle Vi, i = 1 bis N, wobei N eine ganze Zahl > 1 ist, umgesetzt wird.

10. Verfahren zum Dekorrelieren von Quantisierungsgeräuschen in einer Sendervorrichtung nach Anspruch 9, das folgende Schritte umfasst:

   eine Größe von Datenpfaden im Block zum Schätzen von Vorverzerrungskoeffizienten (19) in jedem Kanal ist überdimensioniert, um zusätzliche Nonlinearitäten einzuführen; und/oder in einer vorherigen Übergangsphase werden deterministische Signale am Eingang der Digital-Analog-Umsetzer (13) bereitgestellt, sodass, bei zwei beliebigen verschiedenen Kanälen, die Amplitude und/oder die Frequenz dieser deterministischen Signale zwischen den Kanälen unterschiedlich ist.

## Claims

1. A transmitter device (10; 50) comprising N channels Vi, i = 1 to N $\geq$ 1, each of said channels Vi comprising:

   - a transmission processing channel adapted to process an input signal and comprising a predistortion block (11), a digital-to-analogue converter (13), a first analogue filter (14) and a power amplifier (16), said transmitter device comprising a transducer device coupled to said processing channel and receiving the input signal once it has been processed by said processing channel, the predistortion block (11) being adapted to apply a predistortion to said input signal, as a function of predistortion coefficients, to compensate for the nonlinearities of the power amplifier;
   - a return channel associated with the transmission processing channel, adapted to receive the signal processed by the processing channel and comprising a second analogue filter (17), an analogue-to-digital converter (18), and a block for estimating predistortion coefficients (19), said block for estimating predistortion coefficients (19) being adapted to estimate predistortion coefficients, as a function of at least said input signal and of a signal, called feedback signal, obtained following at least the successive operations, on the received processed signal, of filtering by the second filter and of converting by the analogue-to-digital converter, and to deliver said estimated predistortion coefficients to the predistortion block;
   wherein the processing channel further has a sigma-delta encoder (12) between the predistortion block and the digital-to-analogue converter, adapted to carry out notably a quantisation;
   said transmitter device (10; 50) being **characterised in that** the block for estimating predistortion coefficients (19) is adapted to estimate said predistortion coefficients as a function of at least said input signal and of a signal resulting from the subtraction, from said feedback signal, of a signal representing the quantisation noise resulting from the quantisation carried out by the sigma-delta encoder (12).

2. The wireless transmitter device (10; 50) according to claim 1, wherein said signal representing the quantisation noise is a function of said quantisation noise shaped by the noise transfer function NTF(z) of the sigma-delta encoder.

**3.** The wireless transmitter device (10; 50) according to claim 1 or 2, adapted to obtain said signal representing the quantisation noise by carrying out at least one of said following operations:

- a filtering and a decimation to adapt the sampling frequency and the bandwidth of the signal representing the quantisation noise to the input signal;
- a filtering to reproduce at least the effect of the first and second filters;
- a FIR-type filtering to reproduce the effect of the first and second filters, the transfer function of said FIR filtering being estimated as a function of the comparison between said feedback signal and a signal obtained from the quantisation noise extracted from the sigma-delta encoder.

**4.** The transmitter device (50) according to one of the preceding claims, wherein N >1.

**5.** The transmitter device (50) according to claim 4, wherein a size of data paths in the block for estimating predistortion coefficients (19) in each channel is oversized to introduce additional nonlinearities; and/or the transmitter device comprises a control block adapted, in a preliminary transitional phase, to trigger the provision of deterministic signals at the input of the digital-to-analogue converters (13), such that, given any two separate channels, the amplitude and/or the frequency of these deterministic signals is different between said channels.

**6.** A method for predistorting in a transmitter device (10; 50) comprising N channels Vi, i = 1 to N ≥ 1, each of said channels Vi comprising:

- a transmission processing channel adapted to process an input signal and comprising a predistortion block (11), a digital-to-analogue converter (13), a first analogue filter (14) and a power amplifier (16), said transmitter device comprising a transducer device coupled to said processing channel and receiving the input signal once it has been processed by said processing channel, the predistortion block (11) being adapted to apply a predistortion to said input signal, as a function of predistortion coefficients, to compensate for the nonlinearities of the power amplifier;
- a return channel associated with the transmission processing channel, adapted to receive the signal processed by the processing channel and comprising a second analogue filter (17), an analogue-to-digital converter (18), and a block for estimating predistortion coefficients (19);
wherein the processing channel further has a sigma-delta encoder (12) between the predistortion block and the digital-to-analogue converter, adapted to carry out notably a quantisation;
said method comprising a step of estimating the predistortion coefficients by said block for estimating predistortion coefficients (19), as a function of at least said input signal and of a signal, called feedback signal, obtained following at least the successive operations, on the received processed signal, of filtering by the second filter and of conversion by the analogue-to-digital converter, said estimated predistortion coefficients being delivered to the predistortion block;
said method being **characterised in that** the block for estimating predistortion coefficients (19) estimates said predistortion coefficients as a function of at least said input signal and of a signal resulting from the subtraction, from said feedback signal, of a signal representing the quantisation noise resulting from the quantisation carried out by the sigma-delta encoder (12).

**7.** The method for predistorting in a transmitter device (10; 50) according to claim 6, according to which said signal representing the quantisation noise is a function of said quantisation noise shaped by the noise transfer function NTF(z) of the sigma-delta encoder.

**8.** The method for predistorting in a transmitter device (10; 50) according to one of claims 6 to 7, according to which said signal representing the quantisation noise is obtained by carrying out at least one of said following operations:

- a filtering and a decimation to adapt the sampling frequency and the bandwidth of the signal representing the quantisation noise to the input signal;
- a filtering to reproduce at least the effect of the first and second filters;
- a FIR-type filtering to reproduce the effect of the first and second filters, the transfer function of said FIR filtering being estimated as a function of the comparison between said feedback signal and a signal obtained from the quantisation noise extracted from the sigma-delta encoder.

**9.** A method for decorrelating quantisation noises in a transmitter device (50), according to which a predistortion method according to claims 6 to 8 is implemented on each of the channels Vi, i = 1 to N, with N being an integer >1.

**10.** The method for decorrelating quantisation noises in a transmitter device according to claim 9, comprising the following steps:

a size of data paths in the block for estimating predistortion coefficients (19) in each channel is oversized to introduce additional nonlinearities; and/or

in a preliminary transitional phase, deterministic signals are provided to the input of the digital-to-analogue converters (13), such that, given any two separate channels, the amplitude and/or the frequency of these deterministic signals is different between said channels.

[Fig. 1]

FIG.1 - AA

[Fig 2]

FIG.2

[Fig 3]

FIG.3

[Fig 4]

FIG.4

[Fig 5]

FIG.5

[Fig 6]

FIG.6

[Fig 7]

EP 4 333 312 B1

FIG.7

[Fig 8]

FIG.8

[Fig 9]

FIG.9

[Fig 10]

100

```
      ┌─────────────────────────────────┐
      │               101               │
      └─────────────────────────────────┘
                       │
                       ▼
      ┌─────────────────────────────────┐
      │               102               │
      └─────────────────────────────────┘
                       │
                       ▼
      ┌─────────────────────────────────┐
      │               103               │
      └─────────────────────────────────┘
                       │
                       ▼
      ┌─────────────────────────────────┐
      │               104               │
      └─────────────────────────────────┘
                       │
                       ▼
      ┌─────────────────────────────────┐
      │               105               │
      └─────────────────────────────────┘
```

FIG.10

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20050110562 A1
- US 20120269291 A1
- WO 2020105040 A1

**Littérature non-brevet citée dans la description**

- **H. QIAN ; H. HUANG ; S. YAO.** A General Adaptive Digital Predistortion Architecture for Stand-Alone RF Power Amplifiers. *IEEE Transactions on Broadcasting,* Septembre 2013, vol. 59 (3), 528-538
- **D. G. PHAM ; P. DESGREYS ; M. A. HUSSEIN ; P. LOUMEAU ; O. VENARD.** Impact of subband quantization on DPD correction performance. *2013 IEEE 20th International Conférence on Electronics, Circuits, and Systems (ICECS),* 2013
- **H. H. BOO ; S. W. CHUNG ; J. L. DAWSON.** Adaptive Predistortion Using a $\Delta\Sigma$ Modulator for Automatic Inversion of Power Amplifier Nonlinearity. *IEEE Transactions on Circuits and Systems II: Express Briefs,* Décembre 2009, vol. 56 (12), 901-905
- **OTHMANI MAROUAN et al.** Delta-Sigma Modulator-Embedded Digital Predistortion for 5G Transmitter Linearization. *IEEE Transactions on Communications,* vol. 70 (8), 5558-5571